# EUROPEAN PATENT SPECIFICATION

(11) **EP 2 647 267 B1**
(45) Date of publication and mention of the grant of the patent: **07.03.2018**
(21) Application number: 11854490.7
(22) Date of filing: 23.12.2011
(51) Int. Cl.: H05K 3/18, H05K 3/06

(54) **METHOD FOR MANUFACTURING PRINTED CIRCUIT BOARD**
VERFAHREN ZUR HERSTELLUNG EINER BESTÜCKTEN LEITERPLATTE
PROCÉDÉ DE FABRICATION DE CARTE DE CIRCUIT IMPRIMÉ

(30) Priority: 27.12.2010 KR 20100136072
(43) Date of publication of application: 09.10.2013
(73) Proprietor: LG Innotek Co., Ltd., Seoul, 04637 (KR)
(72) Inventor: MAENG, Il Sang, Seoul 100-714 (KR)
(74) Representative: Novagraaf Technologies
(86) International application number: PCT/KR2011/010065
(87) International publication number: WO 2012/091373

(56) References cited:
- EP-A2- 1 261 021
- JP-A- 2010 080 946
- JP-A- 2010 080 946
- KR-A- 20060 108 104
- KR-B1- 100 797 685
- US-A- 5 764 119
- US-A1- 2004 226 827
- US-A1- 2006 057 341
- US-A1- 2009 236 627

## Description

### Technical Field

The embodiment relates to a method for manufacturing a printed circuit board.

### Background Art

A printed circuit board (PCB) is formed by printing circuit line patterns including conductive materials, such as copper, on an electrical insulating substrate. The PCB refers to a board where electronic components are not yet mounted thereon. In detail, the PCB refers to a circuit substrate on which the mounting position for each component is defined and circuit patterns are printed on a flat plate to connect the components with each other such that various types of electronic devices can be mounted on the flat plate.

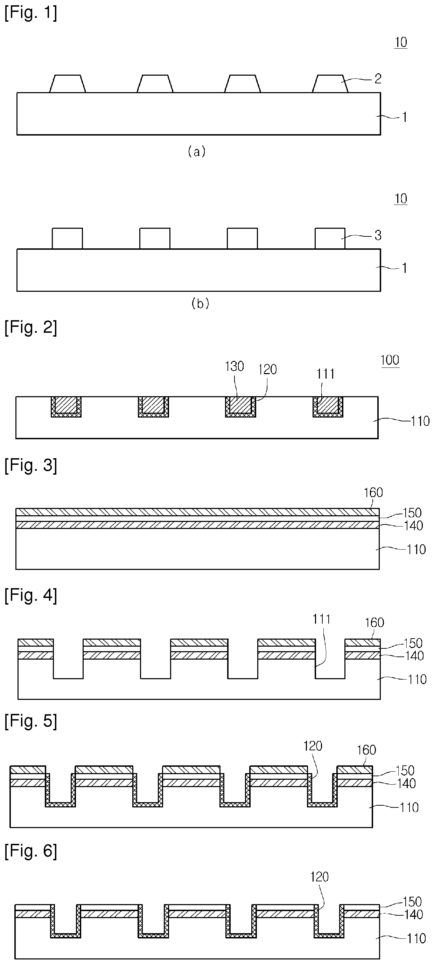

FIGS. 1A and 1B show a general PCB.

Referring to FIGS. 1A and 1B, the general PCB 10 includes an insulating substrate 1 and circuit patterns 2 and 3 including conductive materials, such as copper, and formed on the insulating substrate 1.

The circuit patterns 2 and 3 can be formed in such a manner that a lateral side of the circuit pattern 2 is inclined by a predetermined angle with respect to a top surface of the substrate 1 as shown in FIG. 1A or the circuit pattern 3 is vertically aligned on the top surface of the substrate 1 as shown in FIG. 1B.

However, in the case that the circuit patterns 2 and 3 are formed on the substrate 1 as shown in FIGS. 1A and 1B, there are limitations to form micro circuit patterns 2 and 3 since the top surface of the substrate 1 is uneven.

For this reason, recently, buried pattern substrates capable of reducing a thickness of the PCB 10 while flattening the top surface of the substrate 1 have been used to achieve the high performance and miniaturization of electronic components.

JP-A-2010 080946 discloses a method for manufacturing a printed circuit board using a precursor before electroplating the circuit pattern.

### Disclosure of Invention

### Technical Problem

The PCB having the buried patterns represents higher bonding strength with respect to an insulating member due to the formation of a base circuit pattern and a contact part, and a pitch of the base circuit pattern and the contact part can be uniformly and finely formed.

### Solution to Problem

The embodiment provides a method for manufacturing a PCB, capable of preventing the PCB from being irregularly plated by selectively performing an electroplating process with respect to buried pattern grooves when buried patterns are formed.

A method and a printed circuit board according to the invention are defined in the appended claims.

### Advantageous Effects of Invention

According to the embodiment, the circuit patterns are formed by filling the grooves of the substrate through the plating process such that the conductive absorption layer can be formed in the circuit patterns, and the electroplating process is selectively performed with respect to the pattern grooves by using the conductive absorption layer as a seed layer. Thus, the plating layer may not be formed on the insulating layer except for the grooves, so the etching process for the electroplating layer may not be necessary. Therefore, the patterns can be stably formed.

### Brief Description of Drawings

FIGS. 1A and 1B are sectional views showing a PCB according to the related art;
FIG. 2 is a sectional view showing a PCB according to the first embodiment;
FIGS. 3 to 8 are sectional views showing a method for manufacturing a PCB shown in FIG. 2;
FIG. 9 is a sectional view showing a PCB according to the second embodiment; and
FIGS. 10 to 14 are sectional views showing a method for manufacturing a PCB shown in FIG. 9.

### Best Mode for Carrying out the Invention

The embodiment relates to a printed circuit board. The printed circuit board includes an insulating substrate having a plurality of circuit pattern grooves, a conductive absorption layer including conductive particles absorbed into inner walls of the circuit pattern grooves and circuit patterns formed on the conductive absorption layer such that the circuit pattern grooves are filled with the circuit patterns. Since the electroplating process is selectively performed with respect to inner portions of the pattern grooves by using the conductive absorption layer as a seed layer, the plating layer is not formed on the insulating layer except for the pattern grooves, so that the etching process for the electroplating layer is not necessary and the patterns are stably formed.

### Mode for the Invention

Hereinafter, embodiments will be described in detail with reference to accompanying drawings so that those skilled in the art can easily work with the embodiments. However, the embodiments may have various modifications.

In the following description, when a predetermined part includes a predetermined component, the predetermined part does not exclude other components, but may further include other components unless otherwise indicated.

The thickness and size of each layer shown in the drawings may be exaggerated, omitted or schematically drawn for the purpose of convenience or clarity. In addition, the size of elements does not utterly reflect an actual size. The same reference numbers will be assigned the same elements throughout the drawings.

In the description of the embodiments, it will be understood that when a layer (or film), a region, or a plate is referred to as being on or under another layer (or film), another region, or another plate, it can be directly or indirectly on the other layer (or film), region, plate, or one or more intervening layers may also be present.

The embodiment provides a printed circuit board (PCB) having buried circuit patterns, in which a conductive absorption layer serves as a seed layer such that the circuit patterns can be uniformly formed.

Hereinafter, the PCB according to the first embodiment will be described with reference to FIGS. 2 to 8.

FIG. 2 is a sectional view showing a PCB according to the first embodiment.

Referring to FIG. 2, the PCB 100 according to the embodiment includes an insulating plate 110 and circuit patterns 130 formed in the insulating plate 110.

The insulating plate 110 may be a support substrate of the PCB formed with a single circuit pattern or may refer to an insulating layer region formed with a circuit pattern 130 in the PCB having a stack structure.

If the insulating plate 110 refers to the insulating layer provided in the stack structure, a plurality of circuit patterns 130 may be continuously formed on or under the insulating plate 110.

The insulating plate 110 may be a thermosetting or a thermoplastic polymer substrate, which can make absorption reaction with a conductive particle, an organic-inorganic composite substrate or a glass fiber embedded substrate. If the insulating plate 110 includes a polymer resin, the polymer resin may be an epoxy-based insulating resin or a polyimide-based resin.

The insulating plate 110 includes circuit pattern grooves 11 to form the circuit patterns 130.

The circuit pattern groove 111 has a width of 3 to 25 and a depth of 3 to 25. Preferably, the circuit pattern groove 111 has a width of 10 and a depth of 10.

A conductive absorption layer 120 is formed in the circuit pattern grooves 111 corresponding to the configuration of the circuit pattern grooves 111.

The conductive absorption layer 120 is a plating seed layer and can be formed through the absorption of conductive particles, preferably, carbon particles in the insulating plate 110.

The circuit patterns 130 for filling the circuit pattern grooves 111 are formed on the conductive absorption layer 120.

The circuit patterns 130 may be formed by using an alloy including at least one of Al, Cu, Pt and Pd. Preferably, the circuit patterns 130 are formed by electroplating copper (Cu) using the conductive absorption layer 120 as a seed layer.

In the case of the PCB 100 shown in FIG. 2, the conductive absorption layer 120 is selectively formed in the circuit pattern grooves 111 of the insulating plate 110, so the circuit patterns 130 are selectively electroplated in the circuit pattern grooves 111. Thus, the circuit patterns 130 can be uniformly formed without over-plated regions.

Hereinafter, the method for manufacturing the PCB 100 shown in FIG. 2 will be described with reference to FIGS. 3 to 8.

FIGS. 3 to 8 are sectional views showing the method for manufacturing the PCB 100 shown in FIG. 2.

First, as shown in FIG. 3, the insulating plate 110 is prepared.

The insulating plate 110 may include polymer materials which can make absorption reaction with conductive particles. The insulating plate 110 may be a thermosetting or a thermoplastic polymer substrate, an organic-inorganic composite substrate or a glass fiber embedded substrate. If the insulating plate 110 includes a polymer resin, the polymer resin may be an epoxy-based insulating resin or a polyimide-based resin.

A first metal layer 140, an insulating layer 150 and a second metal layer 160 are sequentially formed on the insulating plate 110.

The first metal layer 140 is a thin copper layer having a thickness of 0.5 or less. When the electroplating process is performed later to form the circuit patterns, the first metal layer 140 serves as a current impression layer to which current is applied.

The insulating layer 150 may be an adhesive layer including a polymer resin. When the electroplating process is performed, the insulating layer 150 serves as an anti-plating layer for preventing the plating material from being applied to other regions except for the circuit pattern grooves 111.

The second metal layer 160 is a thin copper layer having a thickness of 1 or less. When the conductive absorption layer 120 is formed, the second metal layer 160 serves as an anti-absorption layer for preventing materials from being absorbed in the insulating layer 150.

Then, as shown in FIG. 4, a laser is irradiated onto the top surface of the insulating plate 110 through the second metal layer 160 to form the circuit pattern grooves 111.

The circuit pattern grooves 111 can be formed by using an excimer laser that irradiates laser beam having a wavelength of ultraviolet band. The excimer laser may include a KrF excimer laser (Krypton Fluorine, central wavelength: 148nm) or an ArF excimer laser (Argon Fluorine, central wavelength: 193nm).

In the case that the circuit pattern grooves 111 are formed by using the excimer laser, a pattern mask is formed to simultaneously form the circuit pattern grooves 111 and the laser beam is selectively irradiated from the excimer laser through the pattern mask.

If the circuit pattern grooves 111 are formed by irradiating the excimer laser beam through the pattern mask, the sectional shape of the circuit pattern groove 111 has a trapezoidal edge or a rectangular edge.

In addition to the excimer laser, a UV laser or an imprinting scheme can be employed to form the circuit pattern grooves 111.

Then, as shown in FIG. 5, the conductive absorption layer 120 is formed along the inner wall of the circuit pattern grooves 111.

The conductive particles, preferably, the carbon particles C are absorbed in the insulating layer to form the conductive absorption layer 120.

For the absorption process of the carbon particles, an exposed surface of the resin constituting the insulating plate 110 and the insulating layer 150 is electrified with a positive charge and the carbon particles with a negative charge are provided in a colloid state so that the carbon particles are primarily absorbed in the resin.

Then, heat is applied to complete the primary absorption process. After that, the carbon particles with a negative charge are provided again in a colloid state and the secondary absorption process is performed, thereby complementing the carbon coverage. As the absorption process has been completed, the drying process is performed such that the carbon particles can be securely absorbed in the resin.

The above electrification and absorption processes may repeat at least two times to form the conductive absorption layer 120.

The carbon particles are absorbed in the inner wall of the circuit pattern grooves 111 of the insulating plate 110 and the lateral side of the insulating layer 150 through the above absorption process, but the carbon particles are not absorbed in the second metal layer 160.

Therefore, as shown in FIG. 5, the conductive absorption layer 120 is formed along the inner wall of the circuit pattern grooves 111.

Next, as shown in FIG. 6, the second metal layer 160 is removed through the etching process so that the insulating layer 150 is exposed.

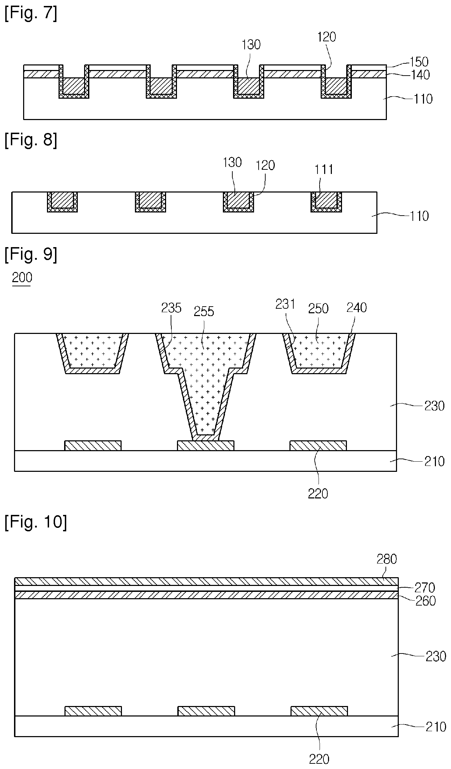

After that, as shown in FIG. 7, the conductive material is subject to the electroplating process by using the conductive absorption layer 120 as a seed layer, thereby forming the buried circuit patterns 130.

The buried circuit patterns 130 can be formed by performing the electroplating process using the conductive absorption layer 120 as a seed layer while controlling the current depending on the area of the plating region. At this time, external voltage is applied to the conductive absorption layer 120 through the first metal layer 140 and the height of the buried circuit patterns 130 can be adjusted corresponding to the depth of the circuit pattern grooves 111 by controlling the voltage.

In addition, the buried circuit patterns 130 may have the height the same as the height of the first metal layer 140.

Since the insulating layer 150 is exposed to the outside, the inner portions of the circuit pattern grooves 111 are selectively plated during the electroplating process.

After that, as shown in FIG. 8, the insulating layer 150 is removed. The insulating layer 150 can be removed through a general desmear process.

In detail, after bulging the surface of the insulating layer 150, the bulged insulating layer 150 is removed by using permanganate, and a wet etching process is performed to neutralize the insulating layer 150, thereby removing the insulating layer.

Then, the first metal layer 140 formed on the surface of the insulating plate 110 is removed through a flash etching process, thereby manufacturing the PCB 100 as shown in FIG. 8.

In this manner, the conductive absorption layer 120 is formed in the circuit pattern grooves 111 such that the conductive absorption layer 120 can be used as a seed layer during the electroplating process, so that the top surface of the insulating plate 110 may not be over-plated when the electroplating process is performed to form the buried circuits. Thus, micro patterns can be formed.

FIG. 9 is a sectional view showing a PCB according to the second embodiment.

Referring to FIG. 9, the PCB 200 according to the second embodiment includes an insulating plate 210, first circuit patterns 220 on the insulating plate 210, an insulating layer 230 and a plurality of second circuit patterns 250.

The insulating plate 210 may be a thermosetting or a thermoplastic polymer substrate, an organic-inorganic composite substrate or a glass fiber embedded substrate. If the insulating plate 210 includes a polymer resin, the polymer resin may be an epoxy-based insulating resin or a polyimide-based resin.

The first circuit patterns 220 are formed on the insulating plate 210 to serve as base circuit patterns.

The first circuit patterns 220 include materials having high electric conductivity and low resistance. For instance, the first circuit patterns 220 can be formed by patterning a thin copper layer into a conductive layer. If the first circuit patterns 220 are prepared as a thin copper layer and the insulating plate 210 includes a resin, the first circuit patterns 220 and the insulating plate 210 may constitute a typical CCL (copper clad laminate).

Meanwhile, the insulating layer 230 is formed on the insulating plate 210 and the first circuit patterns 220 are buried in the insulating layer 230.

A plurality of insulating layers 230 can be provided, in which each insulating layer 230 includes a polymer resin.

The insulating layer 230 includes via holes 235 to expose the first circuit patterns 220 and circuit pattern grooves 231 to form the second circuit patterns 250.

Each circuit pattern groove 231 has a width in the range of 3 to 25, and a depth in the range of 3 to 25. In addition, the via hole 235 has a diameter of about 80 or less and a depth of about 100 or less.

A conductive absorption layer 240 is formed in the via holes 235 and the circuit pattern grooves 231 of the insulating layer 230 corresponding to the configuration of the circuit pattern grooves 231.

The conductive absorption layer 240 is a plating seed layer and can be formed through the absorption of conductive particles, preferably, carbon particles in the insulating layer 230.

The second circuit patterns 250 and vias 251 are formed on the conductive absorption layer 240 to fill the circuit pattern grooves 231 and the via holes 235, respectively.

The second circuit patterns 250 and vias 251 are simultaneously formed by using an alloy including at least one of Al, Cu, Pt and Pd. Preferably, the second circuit patterns 250 and vias 251 include Cu.

The second circuit patterns 250 and vias 251 can be formed by performing the electro copper plating process using the conductive absorption layer 240 as a seed layer.

Hereinafter, the method for manufacturing the PCB 200 shown in FIG. 9 will be described with reference to FIGS. 10 to 14.

FIGS. 10 to 14 are sectional views showing the method for manufacturing the PCB 200 of FIG. 9.

First, as shown in FIG. 10, the first circuit patterns 220 are formed on the insulating plate 210 and the insulating layer 230 is formed on the insulating plate 210 such that the first circuit patterns 220 are buried in the insulating layer 230.

The insulating plate 210 and the first circuit patterns 220 can be formed by etching the thin copper layer of the CCL (copper clad laminate) according to the design of the first circuit patterns 220. Otherwise, the insulating plate 210 and the first circuit patterns 220 can be formed by etching the thin copper layer after depositing the thin copper layer on a ceramic substrate.

At this time, as shown in FIG. 9, the first circuit patterns 220 can be connected to the second circuit patterns 250 through the via holes 235.

The insulating layer 230 may include a thermosetting resin. The insulating layer 230 can be formed by coating a B-stage resin on the insulating plate 210 at a predetermined thickness and curing the B-stage resin by applying heat and pressure to the B-stage resin. It is also possible to provide a plurality of insulating layers 230.

A first metal layer 260, an interlayer dielectric layer 270 and a second metal layer 280 are sequentially formed on the insulating layer 230.

The first metal layer 260 is a thin copper layer having a thickness of 0.5 or less. When the electroplating process is performed later to form the second circuit patterns 250, the first metal layer 260 serves as a current impression layer to which current is applied.

The interlayer dielectric layer 270 may be an adhesive layer including a polymer resin. When the electroplating process is performed, the interlayer dielectric layer 270 serves as an anti-plating layer for preventing the plating material from being applied to other regions except for the circuit pattern grooves 231.

The second metal layer 280 is a thin copper layer having a thickness of 1 or less. When the conductive absorption layer 240 is formed, the second metal layer 280 serves as an anti-absorption layer for preventing materials from being absorbed in the interlayer dielectric layer 270 formed under the second metal layer 280.

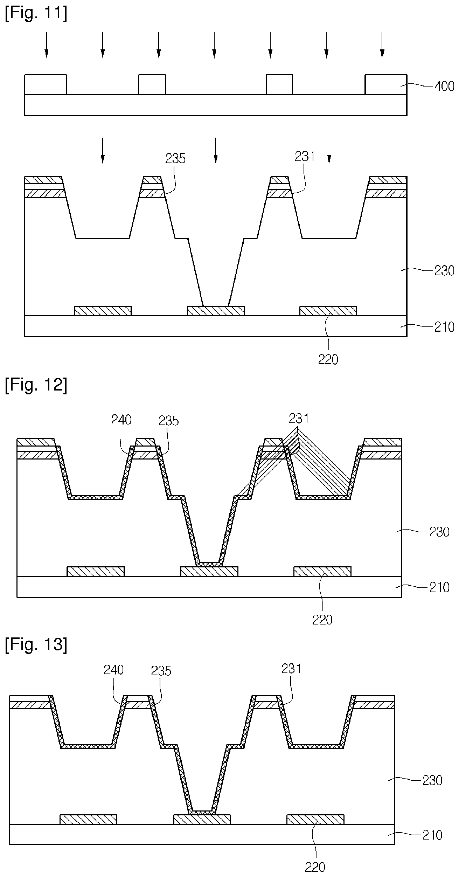

Then, as shown in FIG. 11, the via holes 235 for exposing the first circuit patterns 220 and the circuit pattern grooves 231 are formed from the second metal layer 280 to the insulating layer 230.

When forming the via holes 235 and the circuit pattern grooves 231, the via holes 235 are primarily formed and then the circuit pattern grooves 231 are formed by an excimer laser.

As shown in FIG. 11, the via holes 235 may have sidewalls inclined at a predetermined angle with respect to a top surface of the substrate. Otherwise, the via holes 235 may have sidewalls vertical to the top surface of the substrate.

The via holes 235 can be formed by using a laser, such as a UV laser or a CO₂ laser.

In addition, the via holes 235 can be formed through a physical scheme. For instance, the via holes 235 can be formed through a drilling process. Further, the via holes 235 can be formed through a selective chemical etching process.

In the case that the circuit pattern grooves 231 are formed by the excimer laser, a pattern mask 400 is formed to simultaneously form the circuit pattern grooves 231 and excimer laser beam is selectively irradiated through the pattern mask 400, thereby forming the circuit pattern grooves 231.

If the circuit pattern grooves 231 are formed by irradiating the excimer laser beam through the pattern mask 400, the sectional shape of the circuit pattern groove 231 has a trapezoidal edge or a rectangular edge as shown in FIG. 11.

At this time, a recess having an area larger than exposed top portions of the via holes 235 can be formed in a region having the via holes 235 in such a manner that the via holes 235 may have the layered structure.

If the via holes 235 have the layered structure, the expanded top portions of the via holes 235 can be used as pads for mounting devices, so the mounting area for the device can be ensured.

Then, as shown in FIG. 12, the conductive absorption layer 240 is formed along the inner walls of the circuit pattern grooves 231 and the via holes 235.

The conductive particles, preferably, the carbon particles C are absorbed in the insulating layer 230 to form the conductive absorption layer 240.

For the absorption process of the carbon particles, an exposed surface of the resin constituting the insulating layer 230 and the interlayer dielectric layer 270 is electrified with a positive charge and the carbon particles with a negative charge are provided in a colloid state so that the carbon particles are primarily absorbed in the resin. The absorption process may repeat at least two times.

As the carbon particles are absorbed in the resin, the carbon particles are formed on the inner walls of the circuit pattern grooves 231 of the insulating layer 230 and the sidewalls of the via holes 235, but the carbon particles are not absorbed in the top surfaces of the first circuit patterns 220 exposed through the via holes 235.

After that, as shown in FIG. 13, the second metal layer 280 is removed through the etching process, thereby exposing the interlayer dielectric layer 270.

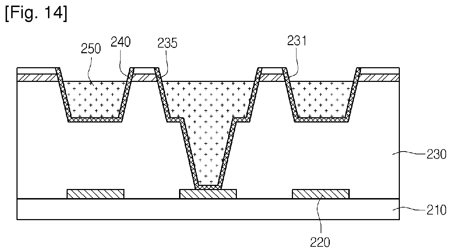

Then, as shown in FIG. 14, the conductive materials are subject to the electroplating process by using the conductive absorption layer 240 as a seed layer, thereby forming the second circuit patterns 250 and the vias 255.

The second circuit patterns 250 and the vias 255 can be formed by performing the electroplating process using the conductive absorption layer 240 as a seed layer while controlling the current depending on the area of the plating region. At this time, external voltage is applied to the conductive absorption layer 240 through the first metal layer 260 and the height of the second circuit patterns 250 and the vias 255 can be adjusted corresponding to the depth of the circuit pattern grooves 231 of the insulating layer 230 by controlling the voltage.

Since the interlayer dielectric layer 270 is exposed to the outside, the inner portions of the circuit pattern grooves 231 and the via holes 235 are selectively plated during the electroplating process.

Then, the interlayer dielectric layer 270 and the first metal layer 260 are sequentially removed, thereby manufacturing the PCB shown in FIG. 9.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method for manufacturing a printed circuit board, the method comprising:
preparing an insulating substrate;
sequentially forming a first metal layer, an interlayer dielectric layer and a second metal layer on the insulating substrate;
performing an etching process from the second metal layer to a surface of the insulating substrate to form a plurality of circuit pattern grooves on the surface of the insulating substrate;
forming a conductive absorption layer through an absorption of conductive particles into inner walls of the circuit pattern grooves; and
forming circuit patterns by performing an electroplating process using the conductive absorption layer as a seed layer such that the circuit pattern grooves are filled with the circuit patterns,
wherein the conductive particles include carbon particles, and
wherein the insulating substrate includes polymer materials that can undergo an absorption reaction with the carbon particles.

2. The method of claim 1, wherein the forming of the conductive absorption layer comprises:
electrifying the insulating substrate with a positive charge;
providing the conductive particles having a negative charge to the insulating substrate; and
applying heat to the insulating substrate such that the conductive particles are selectively absorbed in the insulating substrate.

3. The method of claim 1, wherein the first and second metal layers are formed by an alloy including copper.

4. The method of claim 1, further comprising removing the second metal layer after forming the conductive absorption layer.

5. The method of claim 1, further comprising removing the first metal layer and the interlayer dielectric layer after forming the circuit patterns.

6. The method of claim 1, wherein the preparing of the insulating substrate comprises:
preparing an insulating plate;
forming base circuit patterns by patterning a thin copper layer on the insulating plate; and
forming an insulating layer on the insulating plate such that the base circuit patterns are covered with the insulating layer,
wherein the circuit pattern grooves are formed on a surface of the insulating layer.

7. The method of claim 6, further comprising forming via holes in the insulating layer to expose the base circuit patterns after forming the insulating layer.

8. A printed circuit board comprising:
an insulating substrate having a plurality of circuit pattern grooves;
a conductive absorption layer including conductive particles absorbed into inner walls of the circuit pattern grooves; and
circuit patterns on the conductive absorption layer, the circuit pattern grooves being filled with the circuit patterns,
wherein the conductive particles include carbon particles, and
wherein the insulating substrate includes polymer materials that can undergo an absorption reaction with the carbon particles.

9. The printed circuit board of claim 8, wherein the conductive absorption layer serves as a seed layer when the circuit patterns are electroplated.

10. The printed circuit board of claim 8, wherein the insulating substrate includes a base substrate, base circuit patterns on the base substrate and an insulating layer where the base circuit patterns are buried, and the circuit pattern grooves are formed on a surface of the insulating layer.

11. The printed circuit board of claim 10, wherein the insulating layer further includes via holes to expose the base circuit patterns.

12. The printed circuit board of claim 11, wherein the conductive absorption layer is formed at lateral sides of the via holes.

## Patentansprüche

1. Verfahren zum Herstellen einer Leiterplatte, wobei das Verfahren umfasst:
Vorbereiten eines isolierenden Substrats;
nacheinander Bilden einer ersten Metallschicht, einer zwischenliegenden dielektrischen Schicht und einer zweiten Metallschicht auf dem isolierenden Substrat;
Durchführen eines Ätzvorgangs von der zweiten Metallschicht zu einer Oberfläche des isolierenden Substrats, um eine Vielzahl von Schaltungsmusterrillen auf der Oberfläche des isolierenden Substrats zu bilden;
Bilden einer leitenden Absorptionsschicht durch ein Absorbieren von leitenden Teilchen in Innenwänden der Schaltungsmusterrillen; und
Bilden von Schaltungsmustern durch Durchführen eines Galvanisiervorgangs unter Verwendung der leitenden Absorptionsschicht als eine Keimschicht derart, dass die Schaltungsmusterrillen mit den Schaltungsmustern gefüllt werden,
wobei die leitenden Teilchen Kohlenstoffteilchen einschließen, und
wobei das isolierende Substrat Polymermaterialien einschließt, die eine Absorptionsreaktion mit den Kohlenstoffteilchen eingehen können.

2. Verfahren nach Anspruch 1, wobei das Bilden der leitenden Absorptionsschicht umfasst:
Elektrisieren des isolierenden Substrats mit einer positiven Ladung;
Bereitstellen der leitenden Teilchen, die eine negative Ladung besitzen, an das isolierende Substrat; und
Anwenden von Wärme auf das isolierende Substrat derart, dass die leitenden Teilchenselektiv in dem isolierenden Substrat absorbiert werden.

3. Verfahren nach Anspruch 1, wobei die erste und zweite Metallschicht von einer Legierung gebildet werden, die Kupfer einschließt.

4. Verfahren nach Anspruch 1, weiter das Entfernen der zweiten Metallschicht nach Bilden der leitenden Absorptionsschicht umfassend.

5. Verfahren nach Anspruch 1, weiter das Entfernen der ersten Metallschicht und der zwischenliegenden dielektrischen Schicht nach Bilden der Schaltungsmuster umfassend.

6. Verfahren nach Anspruch 1, wobei das Vorbereiten des isolierenden Substrats umfasst:
Vorbereiten einer isolierenden Platte;
Bilden von Grundschaltungsmustern durch Aufmustern einer dünnen Kupferschicht auf die isolierende Platte; und
Bilden einer isolierenden Schicht auf der isolierenden Platte derart, dass die Grundschaltungsmuster mit der isolierenden Schicht bedeckt sind,
wobei die Schaltungsmusterrillen auf einer Oberfläche der isolierenden Schicht gebildet werden.

7. Verfahren nach Anspruch 6, weiter das Bilden von Durchgangslöchern in der isolierenden Schicht umfassend, um die Grundschaltungsmuster nach Bilden der isolierenden Schicht freizulegen.

8. Leiterplatte, umfassend:
ein isolierendes Substrat, das eine Vielzahl von Schaltungsmusterrillen besitzt;
eine leitende Absorptionsschicht, die leitende Teilchen einschließt, die in Innenwänden der Schaltungsmusterrillen absorbiert sind; und
Schaltungsmuster auf der leitenden Absorptionsschicht, wobei die Schaltungsmusterrillen mit den Schaltungsmustern gefüllt sind,
wobei die leitenden Teilchen Kohlenstoffteilchen einschließen, und
wobei das isolierende Substrat Polymermaterialien einschließt, die eine Absorptionsreaktion mit den Kohlenstoffteilchen eingehen können.

9. Leiterplatte nach Anspruch 8, wobei die leitende Absorptionsschicht als eine Keimschicht dient, wenn die Schaltungsmuster galvanisiert werden.

10. Leiterplatte nach Anspruch 8, wobei das isolierende Substrat ein Grundsubstrat, Grundschaltungsmuster auf dem Grundsubstrat und eine isolierende Schicht einschließt, in der die Grundschaltungsmuster vergraben sind, und die Schaltungsmusterrillen auf einer Oberfläche der isolierenden Schicht gebildet sind.

11. Leiterplatte nach Anspruch 10, wobei die isolierende Schicht weiter Durchgangslöcher einschließt, um die Grundschaltungsmuster freizulegen.

12. Leiterplatte nach Anspruch 11, wobei die leitende Absorptionsschicht an seitlichen Seiten der Durchgangslöcher gebildet ist.

## Revendications

1. Procédé de fabrication d'une carte de circuit imprimé, le procédé comprenant :
la préparation d'un substrat isolant ;
la formation séquentielle d'une première couche de métal, d'une couche diélectrique intercouche et d'une deuxième couche de métal sur le substrat isolant ;
la réalisation d'un processus de gravure de la deuxième couche de métal à une surface du substrat isolant pour former une pluralité de rainures de motif de circuit sur la surface du substrat isolant ;
la formation d'une couche d'absorption conductrice par une absorption de particules conductrices dans des parois intérieures des rainures de motif de circuit ; et
la formation de motifs de circuit par réalisation d'un processus d'électrodéposition en utilisant la couche d'absorption conductrice en tant que couche d'ensemencement de sorte que les rainures de motif de circuit soient remplies de motifs de circuit,
dans lequel les particules conductrices comprennent des particules de carbone, et
dans lequel le substrat isolant comprend des matériaux polymères qui peuvent subir une réaction d'absorption avec les particules de carbone.

2. Procédé selon la revendication 1, dans lequel la formation de la couche d'absorption conductrice comprend :
l'électrification du substrat isolant avec une charge positive ;
la fourniture des particules conductrices ayant une charge négative au substrat isolant ; et
l'application de chaleur au substrat isolant de sorte que les particules conductrices soient sélectivement absorbées dans le substrat isolant.

3. Procédé selon la revendication 1, dans lequel les première et deuxième couches de métal sont formées par un alliage comprenant du cuivre.

4. Procédé selon la revendication 1, comprenant en outre le retrait de la deuxième couche de métal après formation de la couche d'absorption conductrice.

5. Procédé selon la revendication 1, comprenant en outre le retrait de la première couche de métal et de la couche diélectrique intercouche après formation des motifs de circuit.

6. Procédé selon la revendication 1, dans lequel la préparation du substrat isolant comprend :
la préparation d'une plaque isolante ;
la formation de motifs de circuit de base par formation d'un motif sur une fine couche de cuivre sur la plaque isolante ; et
la formation d'une couche isolante sur la plaque isolante de sorte que les motifs de circuit de base soient couverts de la couche isolante,
dans lequel les rainures de motif de circuit sont formées sur une surface de la couche isolante.

7. Procédé selon la revendication 6, comprenant en outre la formation de trous d'interconnexion dans la couche isolante pour exposer les motifs de circuit de base après formation de la couche isolante.

8. Carte de circuit imprimé comprenant :
un substrat isolant ayant une pluralité de rainures de motif de circuit ;
une couche d'absorption conductrice comprenant des particules conductrices absorbées dans des parois intérieures des rainures de motif de circuit ; et
des motifs de circuit sur la couche d'absorption conductrice, les rainures de motif de circuit étant remplies de motifs de circuit,
dans laquelle les particules conductrices comprennent des particules de carbone, et
dans laquelle le substrat isolant comprend des matériaux polymères qui peuvent subir une réaction d'absorption avec les particules de carbone.

9. Carte de circuit imprimé selon la revendication 8, dans laquelle la couche d'absorption conductrice sert de couche d'ensemencement lorsque les motifs de circuit sont électrodéposés.

10. Carte de circuit imprimé selon la revendication 8, dans laquelle le substrat isolant comprend un substrat de base, des motifs de circuit de base sur le substrat de base et une couche isolante où les motifs de circuit de base sont noyés, et les rainures de motif de circuit sont formées sur une surface de la couche isolante.

11. Carte de circuit imprimé selon la revendication 10, dans laquelle la couche isolante comprend en outre des trous d'interconnexion pour exposer les motifs de circuit de base.

12. Carte de circuit imprimé selon la revendication 11, dans laquelle la couche d'absorption conductrice est formée au niveau de côtés latéraux des trous d'interconnexion.
